(19) **Europäisches Patentamt**
**European Patent Office**
**Office européen des brevets**

(11) **EP 2 141 543 B1**

(12) **EUROPEAN PATENT SPECIFICATION**

(45) Date of publication and mention
of the grant of the patent:
**06.12.2017 Bulletin 2017/49**

(51) Int Cl.:
*G03F 7/00* (2006.01)     *G03C 3/00* (2006.01)

(21) Application number: **09163152.3**

(22) Date of filing: **18.06.2009**

(54) **Packaging assembly for flexographic printing plates**

Verpackungsanordnung für Flexodruckplatten

Ensemble d'emballage pour plaques d'impression flexographique

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **02.07.2008 US 217289**

(43) Date of publication of application:
**06.01.2010 Bulletin 2010/01**

(73) Proprietor: **E. I. du Pont de Nemours and Company Wilmington, DE 19805 (US)**

(72) Inventors:
• **Bohn, Johannes**
  **63225 Langen (DE)**
• **Do, Ly Phuoc**
  **63225 Langen (DE)**
• **Dudek, Dietmar**
  **63225 Langen (DE)**
• **Frey, Karl-Heinz**
  **64560 Riedstadt (DE)**
• **Herget, Harald, K.**
  **60437 Frankfurt /Main (DE)**
• **Lehnunh, Kurt**
  **64291 Darmstadt (DE)**
• **Pistor, Johann**
  **63110 Rodgau-Weiskirchen (DE)**
• **Sschmutz, Traugott**
  **63739 Aschaffenburg (DE)**
• **Simon, Reimund**
  **63633 Birstein (DE)**
• **Wiedemann, Karl-Heinz**
  **63322 Roedermark (DE)**

(74) Representative: **Towler, Philip Dean et al Dehns**
**St Bride's House**
**10 Salisbury Square**
**London EC4Y 8JD (GB)**

(56) References cited:
**EP-A- 0 528 395     EP-A- 0 955 564**
**EP-A- 1 479 824     EP-A- 1 816 515**
**EP-A1- 1 516 745     JP-A- 9 292 713**

**Description**

BACKGROUND OF THE INVENTION

1. Field of the Invention

The invention pertains to a packaging unit for flexographic printing plates, and in particular for photopolymerizable printing plates useful for relief printing.

2. Description of Related Art

Flexographic printing plates are well known for use in relief printing on a variety of substrates and can be prepared from photosensitive printing elements containing a layer of a photosensitive composition, such as those described in U.S. Patents 4,323,637 and 4,427,759. Photosensitive elements generally have a layer of a photopolymerizable composition interposed between a support and a cover sheet or multilayer cover element. The support is a carrier of the photopolymerizable layer and the cover sheet protects the photopolymerizable layer from outside influences. Upon imagewise exposure of the photosensitive element to actinic radiation, photopolymerization of the photosensitive composition occurs in the exposed areas, thereby curing and rendering insoluble the exposed areas of the layer. Imagewise exposure can be carried out by exposing the element through an image-bearing phototool, which may be referred to as an analog exposure or process; or, by first exposing the element through an in-situ mask formed digitally with use of laser radiation or ink-jetting adjacent the photopolymerizable layer, which may be referred to as a digital exposure or direct-to-plate process. The uncured regions are soluble to solvents used during washout development and/or can melt, soften, or flow upon heating. The element is then treated with a suitable solution or with heat to remove unexposed areas (i.e., uncured areas) of the photopolymerizable layer, leaving a relief image suitable for flexographic printing. The photosensitive element may also be referred to as a blank printing plate, i.e., a printing plate that has not been exposed or imaged.

Conventionally, the blank printing plates are delivered to a customer by the printing plate manufacturer, and are then prepared by the customer into a form suitable for printing. Depending on the customer's capabilities and/or the field of application, the customer prepares the printing form as described above by imagewise exposing the blank printing plates and treating the imaged printing plates.

Much care must be taken when transporting the blank printing plates. It is, for example, imperative to ensure that the photopolymerizable layer which has not yet been exposed and therefore not yet cured is not damaged or that the entire blank printing plate does not become deformed. For transportation, two or more printing plate blanks are arranged one on top of another as a stack in packaging containers. Typically packaging containers are rectangular in shape. To better protect the stack, foam layers may be arranged between the blank printing plates. The packaging container may include rigid boards, for example, high density fibre (HDF) boards, honeycomb bases made of cardboard, multilayer honeycomb bases, plywood bases and combinations thereof, as an upper and/or lower covering in order to provide more stability to the container. Typically, there is anywhere from 5-20 printing plate blanks in a packaging container. However, it is not unusual for a packaging container to have up to 50 blank printing plates on top of one another. A plurality of said packaging containers may in turn be stacked on top of one another when in storage and for transportation.

A problem sometimes arises that the blank printing plates in the individual packaging containers become deformed, that is, the planar shape of the blank printing plates change shape or warp. The deformation typically occurs in the bottom most blank printing plate in a container or box having more than one plate stacked on top. The deformation of blank printing plates is particularly problematic in certain conditions, for example, when a plurality of packaging containers (such as 4 to 12 packaging containers, each containing a stack of blank printing plates) are stacked on top of one another and stored or transported, and/or during extended periods of storage or transportation. The deformation is manifested in the photopolymerizable layer which develops a pattern of changing thickness, resulting in the blank printing plate having an appearance similar to an undulating washboard-shaped structure. For example, the blank printing plate may exhibit differences in the thickness of the photopolymer layer of up to 50 - 100 $\mu$m. For quality reasons a difference of about 25 $\mu$m or less is acceptable. The middle or central portion of a blank printing plate typically exhibits the washboard deformation, with the edges being affected to a lesser extent. In general, initially the bottom-most blank printing plate in a packaging container can become deformed in this way. However, other blank printing plates in a packaging container can also exhibit the deformation. Blank printing plates that are in an uppermost packaging container or in upper packaging containers in a stack may exhibit the washboard deformation. The blank printing plates in a packaging container having the appropriate number of blank printing plates but is stored and/or transported alone, (that is, not stored or transported as part of a stack of packaging container) may also become deformed. The deformation in planar shape has a considerable effect on the quality of the final printing plates and renders the printing plates useless for their original application.

So a need arises to provide a solution that reduces or eliminates washboard-like defects in photopolymerizable printing plates, which is also easy to use, and can be easily integrated into a process for packing the printing plates.

EP 0528395 discloses a presensitised plate for use in making lithographic printing plates. JP 09-292713 discloses a photosensitive material with an interleaving paper.

## SUMMARY OF THE INVENTION

The present invention relates to a packaging assembly for flexographic printing plates that includes a packaging container having a base, and at least one flexographic printing plate positioned in the container adjacent the base, the at least one flexographic printing plate comprising an elastomeric photopolymerisable layer of a composition comprising a binder at least one monomer, and at least one photoinitiator, or photoinitiator system, that is adjacent a support, the elastomeric photopolymerisable layer having a thickness between 0.6 and 7 mm, wherein an interface having a coefficient of static friction of less than 0.30 is disposed between the plate and the base.

The present invention further relates to a method for packing a flexographic printing plate that includes providing a packaging container having a base, positioning at least one flexographic printing plate in the container adjacent the base, the at least one flexographic printing plate comprising an elastomeric photopolymerisable layer of a composition comprising a binder at least one monomer, and at least one photoinitiator, or photoinitiator system, that is adjacent a support, the elastomeric photopolymerisable layer having a thickness between 0.6 and 7 mm, and disposing an interface having a coefficient of static friction of less than 0.30 between the plate and the base.

## DETAILED DESCRIPTION OF THE PREFERRED EMBODIMENTS

It has surprisingly been found that the packaging assembly of the present invention eliminates or at least reduces the occurrence of defects having the washboard-like structure in a flexographic printing plate or flexographic printing plates placed in a packaging container. The washboard defect is a deformation of the planarity of blank flexographic printing plates which manifests in the photopolymerizable layer as a pattern of changing thickness, of up to 50 - 100 $\mu$m. Even during extended storage periods of four weeks and more, the flexographic printing plates packed in the packaging assembly of the present invention are not noticeably deformed. The packaging assembly provides particular advantage in the prevention of the washboard-like defect for a bottom most flexographic printing plate, i.e., the plate closest to the bottom of the packaging container, in a stack of more than one plate in the container. The packaging assembly can prevent the occurrence of the washboard defect in flexographic printing plates even in multiple packaging assemblies each having four or more flexographic printing plates, in which the multiple packaging assemblies are stacked on top of one another for extended storage periods and/or during transport. The ability of the packaging assembly to prevent the washboard defect in flexographic printing plates is all the more surprising since this improvement is observed across a variety of photopolymerizable printing plates having different hardness and different thickness.

The flexographic printing plates for use in the present invention are in particular photopolymerizable printing plates. The flexographic printing plates are blank printing plates. The term "blank printing plate" is understood in this context as a flexographic printing plate which has not been subjected to imagewise exposure and treatment. This means that the photopolymerizable layer is present in an unpolymerized or uncured state and is capable of being polymerised by actinic radiation. For simplicity, and unless otherwise indicated, flexographic printing plates are uncured printing plates, which may be referred to herein as blank printing plates, printing plates, and even plates.

The packaging assembly for flexographic printing plates of the present invention includes a packaging container having a base, and at least one flexographic printing plate positioned in the container adjacent the base, wherein disposed between the plate and the base is an interface having a coefficient of friction of less than 0.30. The flexographic printing plate arranged adjacent the base, i.e., closest the base, may be referred to herein as a bottom printing plate or bottommost flexographic printing plate.

The packaging container is a box or carton that provides a protective space to hold or contain one or more flexographic printing plates for transport and storage generally from time of manufacture to time of use by a customer. Typically the packaging container has a rectangular shape to accommodate the planar shape of the flexographic printing plates. The packaging container is appropriately sized to be at least as large as the planar dimensions (width and length) of the particular flexographic printing plates contained therein, and of sufficient height to accommodate the number of plates having a particular thickness that are held in the container. The packaging container can have planar dimensions larger than the planar dimensions of the flexographic printing plates, in which case filler materials, such as cardboard or foam, may be placed in the open space between the container and the plates. Although not limited, packaging containers can contain 1 to 50 or more flexographic printing plates, and typically contain between 4 to 50 flexographic printing plates. The packaging container includes a base, side walls connected to the base on a perimeter of the base, and optionally, a cover or lid. The base includes an interior surface above which the one or more plates, the interface, and optional other layers are located in ordered embodiments according to the present invention. The walls are perpendicular to the base and have sufficient height to encompass the one or more flexographic printing plates that are a stacked within the container. In one embodiment, the cover is separate from the base and walls of the container and can be positioned to close the container by covering a flexographic printing plate on top of the stack and optionally the side walls. In another embodiment, the cover is integral with one side wall and can be positioned to close the container by folding the cover over the topmost flexographic printing plate, and optionally the side walls. The packaging container is not limited to these two embodiments as other embodiments of the packaging container can be contemplated by those of ordinary skill in the art.

Materials suitable for use in forming the packaging container are not limited. The packaging container can include one or more materials in each of the base, side walls, and optional cover. Materials suitable for use in the packaging container, include but are not limited to, card stock (which may be referred to as card), cardboard, wood, plywood, wood composites or similar materials, wood laminates or similar materials, and fibre boards or similar materials. Fibre boards can be high density fibre board (HDF) and medium density fibre boards (MDF) or similar materials. The materials may be uncoated or coated with one or more layers of protective materials, strengthening materials and/or materials for aesthetic or identifying purposes. The base may be reinforced with, for example, honeycomb construction, and/or can be strengthened by one or more packaging components arranged inside. In some embodiments, the interior surface of the base is a covering of cardstock or paper. Except for an embodiment where the interface is integral to the packaging container, boxes or containers for use as the packaging container for flexographic printing plates are conventional in the art and can be supplied from most any manufacturer of packaging boxes.

The packaging assembly may optionally include one or more intermediate layers interspersed with the one or more blank flexographic printing plates. In some embodiments, an intermediate layer may be inserted or placed between each adjacent blank flexographic printing plate in a stack of plates. The packaging assembly may include an intermediate layer arranged between the cover and a flexographic printing plate at the top of the stack, which can be used alone or in addition to the optional intermediate layers between the plates. The packaging assembly may include an intermediate layer arranged between the base and the bottom flexographic printing plate, which can be used alone or in addition to the optional intermediate layers between the plates. The intermediate layer between the base and bottom flexographic printing plate can be the same or different than the optional intermediate layer/s between the plates. Examples of a suitable intermediate layer include, but are not limited to, foam sheets, and polystyrene sheets. The foam can be open-celled or close-celled foam. Materials suitable for use as the foam sheet are not limited, and can include, for example, polyolefin foam, such as polyethylene foam. The intermediate layer has a thickness that can range in some embodiments from 0.5 to 5 mm, and in other embodiments from 1 to 3 mm. In a packaging assembly the type and thickness of the intermediate layer between the flexographic printing plates can be the same or different than the type and thickness of the intermediate layer between the bottom plate and the base.

The packaging assembly is a singular packaging container containing one or more flexographic printing plates. In some embodiments, the packaging assembly includes at least two flexographic printing plates in the packaging container. In other embodiments, the packaging assembly includes four or more flexographic printing plates in the packaging container. In yet other embodiments, the packaging assembly includes 5 to 20 flexographic printing plates in the packaging container. For simplicity during storage and transport, two or more packaging assemblies, i.e., a multiplicity of packaging assemblies may be grouped together and placed on top of another as a stack or as multiple stacks on a transport pallet. As such, boards made of wood, plywood, wood composites, laminates, and fibres may be arranged both between the stacked packaging containers and between a packaging container and the transport pallet.

The present invention includes an interface having a coefficient of friction less than 0.30 disposed between the base of the packaging container and a flexographic printing plate positioned in the container adjacent the base. The presence of the interface having the coefficient of friction less than 0.30 provides a surface that allows the at least one plate adjacent the base to float or shift freely within the packaging container. The interface having the coefficient of friction less than 0.30 is capable of interrupting contact between the base and the flexographic printing plate such that the flexographic printing plate/s is not influenced by movement of the base during storage and transport, or alterations of the base that can occur from stacking of multiple packaging assemblies. The interface thus uncouples the flexographic printing plate from the base of the packaging container so that the photopolymerizable layer of the flexographic printing plate maintains its planar uniformity and is not influenced by the stresses induced in the base of the packaging container to create non-uniform washboard-like defect. The interface can be incorporated into the packaging assembly as a separate component referred to herein as a carrier, or can be integrated into the packaging container.

In the embodiment in which the interface is a carrier, the carrier has a form that is sheet-like or planar and is disposed between the bottom-most flexographic printing plate and the base. It should be understood that relative to the interface and base, the flexographic printing plate of the at least one flexographic printing plate is the bottom flexographic printing plate, i.e., the flexographic printing plate closest to the base. The carrier may be in direct contact with at least the flexographic printing plate or the base, but need not contact both the plate and the base. In some embodiments the planar surface of the carrier is contiguous with the flexographic printing plate. In other embodiments, the planar surface of the carrier is contiguous with the base of the container. In other embodiments, the planar surface of the carrier is contiguous with the intermediate layer. Since the optional intermediate layer can be located between the flexographic printing plate and the base, the carrier can be adjacent or in contact with the intermediate layer. Thus, the carrier may be disposed between the flexographic printing plate and the intermediate layer, which is arranged on the base; or, the carrier may be disposed between the base and the intermediate layer, and the flexographic printing plate is arranged on top of the intermediate layer. The intermediate layer that is between the bottom flexographic printing plate and the base and has a thickness between 1 to 3 mm, is thin enough to compress under the at least one flexographic printing plate, so that the interface with the coefficient of friction will allow the at least one plate (adjacent the base) to maintain its planar uniformity and is not influenced by the stresses in the packaging container to create non-uniform washboard-like defect.

The carrier has a planar surface that provides the packaging assembly with the interface having a coefficient of friction less than 0.30. In some embodiments, the planar surface of the carrier that provides the interface is in direct contact with the base, or with the support side of the flexographic printing plate, or with the coversheet side of the flexographic printing plate. In other embodiments, the planar surface of the carrier that provides the interface is in direct contact with the intermediate layer and can provide the advantage of a reduction or preventing washboard-like defect in flexographic printing plates, even though the interface is not in direct contact with the base or the flexographic printing plate.

In one embodiment, the carrier may be formed of a material that inherently provides the coefficient of friction of less than 0.30. A material suitable for forming the carrier that inherently has the necessary coefficient of friction is a non-stick material (i.e., material having anti-adhesion properties) which includes, but is not limited to, fluoropolymers. The non-stick material should be capable of forming a self-supporting film or sheet.

In another embodiment, the carrier may be prepared from a foil-like member that is modified in such a way that the modified foil-like member has the necessary coefficient of friction. Materials suitable for use as the foil-like member which can be modified, include, but are not limited to, papers, metals, and polymeric films. Examples of suitable polymeric films include polyesters, such as polyethylene terephthalate, and polybutylene terephthalate; polyolefins, such as polyethylenes; polypropylenes; polyurethanes; polyamides; polystyrenes; polycarbonates; and combinations thereof. The foil-like member may also be formed from blends or mixtures of two or more polymers.

The foil-like member has two planar surfaces in which one or both planar surfaces can be modified with one or more layers of a low-friction material that will provide the necessary coefficient of friction for use as the carrier. The foil-like member can be modified with treatment or by application of the low-friction material by any method suitable. In most instances, the low-friction material is applied as a coating to the foil-like member: unilaterally, coated on one planar surface; or, bilaterally, coated on both planar surfaces of the foil-like member. The low-friction materials include, but are not limited to, silicone or silicone-containing materials, fluorinated polymers, fluorinated polymers copolymerized with other polymers, and blends and mixtures thereof. An example of a suitable fluorinated polymer is a fluorinated polyolefin, such as, polytetrafluoroethylene. Preferred carriers are foil-like members having at least one planar surface coating of a low-friction material. Particularly preferred carriers are polyester films having a coating of a silicone material, a silicone-containing material, or a fluorinated polymer.

The carrier has a thickness that is not particularly limited. In some embodiments, the carrier to be used in accordance with the invention has a thickness between 0.1 mm and 0.5 mm, and preferably between 0.125 mm and 0.25 mm. In most embodiments, the carrier has a planar size (i.e., width and length) that is at least the same as the planar dimensions of the at least one printing plate in the packaging container. It is preferred that the carrier have a smooth, scratch-free surface, particularly as the interface surface.

In the embodiment in which the interface is integrated with the packaging container, the interface is associated with at least one component of the container, to provide the interface with a coefficient of friction of less than 0.30. The interface is associated with at least the base of the container. In one embodiment, the interior surface of the base of the container can be coated with a low-friction material. In another embodiment, the base of the container can include as its interior surface a layer that is formed of a material that either inherently provides the desired coefficient of friction, or is modified in such a way that the modified layer has the desired coefficient of friction. As such, the interior surface with the modified layer would be oriented to face the flexographic printing plate or other intermediate layers. The layer could be formed as a unit with the base and/or the other components of the packaging container. Alternatively, the layer could be secured to the base as the interior surface of the container with a bonding or adhesive materials, or by joining methods, such as lamination. In yet another embodiment, the base of the container (and optionally the walls) can be formed from a material that inherently provides the desired coefficient of friction or can be formed of a composite of materials that includes a low-friction material. In either case the resulting interior surface of the base should provide the desired coefficient of friction as the interface. In some instances, it may be necessary to reinforce the base of the packaging container. The materials suitable as the low friction materials as described above relative to the carrier embodiments are also suitable for use as the coating of low-friction material on the base in the present integrated component embodiments. The materials suitable as the carrier, including the foil-like member and low-friction modification materials as described above relative to the carrier embodiments are also suitable for use as the layer in the present integrated component embodiments. The interface integrated into the base of the packaging container can be in direct contact with at least one printing plate, or can contact the intermediate foam layer.

The interface provides a surface between the base and the flexographic printing plate with the coefficient of friction of less than 0.30, that is, a coefficient of friction between 0 and 0.30. Interfaces having coefficient of friction less than 0.30 represent materials that slide relatively easily, i.e., interface having low friction. In some embodiments, the interface provides a surface with the coefficient of friction between 0 and 0.25. In other embodiments, the interface provides a surface with the coefficient of friction between 0 and 0.2. In yet other embodiments, the interface provides a surface with the coefficient of friction between 0.04 and 0.25.

In the present invention the coefficient of friction as used herein is a coefficient of static friction. For the purposes of the present invention, the coefficient of friction may also be referred to as the coefficient of static friction. The coefficient of static friction is a dimensionless scalar value that characterizes the static friction at an interface between two bodies, including at an interface between two bodies made of the same material. The static friction coefficient ($\mu_s$ or coefficient of static friction) between two solid surfaces is defined as the ratio of the tangential force required to produce sliding divided by the normal force between the surfaces. If a body rests on an incline plane the body is prevented from sliding down the plane because of frictional resistance. If the angle of the incline plane is increased, there will be an angle at which the body begins to slide down the plane. This is the angle of repose and the tangent of this angle is the same as the coefficient of static friction. The preferred method to determine an accurate coefficient of static friction between two materials is to conduct experiments.

For the present invention, the coefficient of static friction is determined according to the following test method. The test method to measure the coefficient of (static) friction was developed to evaluate materials for use as the interface in the packaging assembly of the present invention. The coefficient of friction of the carrier or integrated component is determined according to the following test method and is performed in a room having between 40 - 60% relative humidity and at a temperature between 15 to 18°C. A wooden board, 20 mm thick and 920 mm long, is used as an incline plane for the test. The interface material to be evaluated for its coefficient of static friction is attached with adhesive tape to cover one side of the wooden board and a side of a 200g calibration weight that faces the board. The calibration weight is placed on the board so that the surfaces of the board and calibration weight that have the interface material are in contact. One end of the wooden board is lifted via a manually-operated hydraulic lift device to a height at which the calibration weight on the board begins to move (down the incline plane of the board). The end of the board is lifted at a continuous rate. The rate at which the end of the board can be lifted is not particularly critical. However, the slower rate of lifting the board, the easier it is to detect the movement of the weight on the board, and the more accurate and/or reproducible the measurement of the height of the board. A suitable rate of lifting the board is between 1 to 3 cm/minute, and preferably about 2 cm/minute. The vertical height of the end of the board that was lifted is measured in millimeters (or according to the same unit used to measure the length of the board). The test can be conducted several times, and the height measurements averaged for calculation of the coefficient of friction. An angle of inclination is an angle created between the horizontal position of the board (prior to lifting) and the inclined position of the board (at the measured height). The tangent of the angle of inclination corresponds to the coefficient of static friction. The coefficient of static friction is determined via known basic trigonometry, based on the measured height (h) and the known length of the board (I). Since the height (h) divided by the length (I) equals the sine of the angle alpha, angle alpha can be calculated. Since angle alpha is known, the tangent of angle alpha can then be calculated to determine the coefficient of static friction. The accuracy of the measurement method for the coefficient of static friction is about +/- 0.02.

According to the above test method, the coefficient of static friction of a commercially-available coated polyester film (MYLAR ® polyethylene terephthalate, type 100A, from DuPont Teijin Films) was measured to be 0.35. This is consistent with the coefficient of static friction of the MYLAR® 100A that is reported by the manufacturer (and measured according to ASTM 1894) as 0.36. (The above described test method for determining the coefficient of static friction is preferred, even if the coefficient of static friction can be conducted according to standard ASTM D1894.)

According to the present invention, there are several possible embodiments of a packaging assembly, and in particular, several possible sequences of plates and layers that can be assembled in the packaging container. One series of embodiments includes the interface in the form of a carrier disposed in a packaging container, the carrier being formed of a material having a coefficient of friction less than 0.30. It should be understood that in all the following possible layer sequence embodiments, the printing plate encompasses stacks of one or more printing plates, and optionally including an intermediate layer between the plates. It should also be understood that in the following possible layer sequence embodiments, the intermediate layer is, for example, a layer of a foam material. Starting from the base of the container and building the layers upward, this first series of possible embodiments is as follows.

| Embodiment | Sequence |
| --- | --- |
| 1A. | base / carrier / printing plate. |

(continued)

| Embodiment | Sequence |
|---|---|
| 1B. | base / intermediate layer / carrier / printing plate |
| 1C. | base / carrier / intermediate layer / printing plate |

In some instances, embodiment 1C is preferred.

Another series of embodiments includes the interface in the form of a carrier disposed in a packaging container, the carrier including a side having a coating of a material that provides the coefficient of friction less than 0.30. Starting from the base of the container and building the layers upward, this second series of possible embodiments is as follows.

| Embodiment | Sequence |
|---|---|
| 2A. | base / carrier with coated side facing the base / printing plate. |
| 2B. | base / carrier with coated side facing the printing plate / printing plate. |
| 2C. | base / intermediate layer / carrier with coated side facing the intermediate layer / printing plate. |
| 2D. | base / intermediate layer / carrier with coated side facing the base / printing plate. |
| 2E. | base / carrier with coated side facing the base / intermediate layer / printing plate. |
| 2F. | base / carrier with coated side facing the intermediate layer / intermediate layer / printing plate. |

In some instances, embodiments 2E and 2F are preferred.

Yet another series of embodiments includes the interface that is integrated with the packaging container to provide the coefficient of friction less than 0.30. The interface can be a coating on the interior surface of the base, or can be a layer on the base forming the interior surface, or base can integrally formed to provide the interior surface with the desired coefficient of friction. Starting from the base of the container and building the layers upward, this third series of possible embodiments includes the following sequences. Additional sequences of layers are possible for this third series of embodiments, but not specifically recited.

| Embodiment | Sequence |
|---|---|
| 3A. | base with interior surface with coating of low friction material /printing plate. |
| 3B. | base with interior surface with coating of low friction material / intermediate layer / printing plate. |
| 3C. | base having a layer of a carrier forming the interior surface / printing plate. |
| 3D. | base having a layer of a carrier forming the interior surface / intermediate layer / printing plate. |
| 3E. | base having a layer of a foil-like member with a modified low-friction surface forming the interior surface / printing plate. |
| 3F. | base having a layer of a foil-like member with a modified low-friction surface forming the interior surface / intermediate layer / printing plate. |

The packaging assembly of the present invention is particularly suited for use with photopolymerizable flexographic printing plates, and applicable across a variety of printing plates of different thickness and different hardness. The present packaging assembly is advantageous for any printing plate having a thickness of its photopolymerizable layer between about 0.6 and 7 mm. The present packaging assembly is advantageous for any printing plate having a Shore A hardness between about 12 and 55.

Printing Plates

The flexographic printing plates of the present invention include at least a support and a photopolymerizable layer, and optionally one or more additional layers. The flexographic printing plate may also be referred to herein as a blank flexographic printing plate, or a photosensitive element.

The photopolymerizable layer is a solid elastomeric layer of a photosensitive composition where the layer can be selectively cured by actinic radiation. As used herein, the term "photopolymerizable" is intended to encompass systems that are photopolymerizable, photocrosslinkable, or both. Throughout this specification actinic radiation will include ultraviolet radiation and/or visible light. The solid layer of the photopolymerizable composition is treated with one or more solutions and/or heat to form a relief suitable for relief printing. As used herein, the term "solid" refers to the physical state of the layer which has a definite volume and shape and resists forces that tend to alter its volume or shape. The layer of the photopolymerizable composition is solid at room temperature, which is a temperature between about 5°C and about 30°C. In some embodiments of the flexographic printing plate blank, a solid layer of the photopolymerizable composition is unpolymerized. In other embodiments of the flexographic printing plate blank, a solid layer of the photopolymerizable composition is primarily unpolymerized, and may include a thin polymerized layer adjacent the base. The photopolymer composition includes a binder, at least one monomer, and at least one photoinitiator or a photoinitiator system.

The binder is not limited and can be a single polymer or mixture of polymers. In some embodiments, the binder is an elastomeric binder. In other embodiments, the binder becomes elastomeric upon exposure to actinic radiation. Binders include natural or synthetic polymers of conjugated diolefin hydrocarbons, including polyisoprene, 1,2-polybutadiene, 1,4-polybutadiene, butadiene/acrylonitrile, and diene/styrene thermoplastic-elastomeric block copolymers. In some embodiments, the binder is an elastomeric block copolymer of an A-B-A type block copolymer, where A represents a non-elastomeric block, and B represents an elastomeric block. The non-elastomeric block A can be a vinyl polymer, such as for example, polystyrene. Examples of the elastomeric block B include polybutadiene and polyisoprene. Suitable thermoplastic elastomeric binders of this type include poly(styrene/isoprene/styrene) block copolymers, poly(styrene/butadiene/styrene) block copolymers and mixtures thereof. The non-elastomer to elastomer ratio is preferably in the range of from 10:90 to 35:65. It is preferred that the binder be present in an amount of at least 60% by weight of the photosensitive layer.

Other suitable elastomeric photopolymer compositions that may be used include polyurethane elastomers. An example of a suitable polyurethane elastomer is the reaction product of (i) an organic diisocyanate, (ii) at least one chain extending agent having at least two free hydrogen groups capable of polymerizing with isocyanate groups and having at least one ethylenically unsaturated addition polymerizable group per molecule, and (iii) an organic polyol with a minimum molecular weight of 500 and at least two free hydrogen containing groups capable of polymerizing with isocyanate groups. For a description of some of these materials see U.S. Pat. No. 5,015,556.

The elastomeric photopolymerizable composition contains at least one compound capable of addition polymerization that is compatible with the binder to the extent that a clear, non-cloudy photosensitive layer is produced. The at least one compound capable of addition polymerization may also be referred to as a monomer and can be a single monomer or mixture of monomers. Monomers that can be used in the photopolymerizable composition are well known in the art and include, but are not limited to, addition-polymerization ethylenically unsaturated compounds with at least one terminal ethylenic group. Monomers having molecular weight less than about 30,000 and typically less than about 5000 can be appropriately selected by one skilled in the art to provide elastomeric property to the photopolymerizable composition. The compound capable of addition polymerization (monomer) is present in an amount of about 5% to about 20%, by weight of the elastomeric composition.

The photoinitiator can be any single compound or combination of compounds which is sensitive to actinic radiation, generating free radicals which initiate the polymerization of the monomer or monomers without excessive termination. Any of the known classes of photoinitiators may be used. Alternatively, the photoinitiator may be a mixture of compounds, one of which provides the free radicals when caused to do so by a sensitizer activated by radiation. Preferably, the initiator is sensitive to visible or ultraviolet radiation.

The photopolymerizable layer can contain other additives depending on the final properties desired. Additional additives to the photopolymerizable layer include sensitizers, spectral sensitizing agents, plasticizers, rheology modifiers, thermal polymerization inhibitors, colorants, processing aids, antioxidants, antiozonants, UV absorber and fillers.

The thickness of the elastomeric photopolymerizable layer is between 0.6 and 7 mm. It can vary over a wide range depending upon the type of flexographic printing plate desired, for example, the photopolymerizable layer can range from about 0.067 inch to about 0.250 inch (about 0.17 cm to about 0.64 cm). In some embodiments, the photopolymerizable printing plate has a Shore A hardness of about 12 to about 55. The Shore A hardness as referred to in the present invention is the hardness of the printing plate blank (i.e., unexposed printing plate) and is determined according to standard DIN 53505-A. The Shore A hardness of the uncured photopolymerizable printing plate may be measured with or without the support.

The flexographic printing plate blanks have a surface area (of a major planar side of the plate) that is dependent upon the ultimate field of application, e.g., size of image being printed on substrate, the type of substrate being printed, the size of printing cylinder on press, etc. The surface area of a flexographic printing plate blank can range from about 0.5 to 3 square meter.

The support can be any material that is conventionally used to prepare flexographic printing plates. The support is planar or has a sheet-like form. Preferably the support is transparent to actinic radiation to accommodate "backflash" exposure through the support. Examples of suitable support materials include polymeric films such those formed by addition polymers and linear condensation polymers, transparent foams and fabrics. Under certain end-use conditions metals, such as aluminum, may also be used as a support, even though a metal support is not transparent to radiation. A preferred support is a polyester film; particularly preferred is polyethylene terephthalate. The support typically has a thickness from 0.002 to 0.050 inch (0.0051 to 0.127 cm). In one embodiment, the thickness for the sheet form is 0.003 to 0.016 inch (0.0076 to 0.040 cm).

Although it is contemplated that the interface having a coefficient of friction less than 0.30 could possibly be integral to the flexographic printing plate, e.g., using a low friction material as the support or coating an exterior surface of the support with a low friction material, this embodiment is generally not preferred. The use of a low friction material integral with the flexographic printing plate support would likely interfere with end-use applications and processes, such as for example, in the mounting of plates with adhesive tape on a printing cylinder.

The flexographic printing plate blank can optionally include an adhesive layer between the support and the photopolymerizable layer; and/or the support can have an adhesion promoting surface, for example by flame-treatment or electron-treatment; and/or the adhesion of the photopolymerizable layer to the support can be enhanced by exposure to actinic radiation through the support.

The photosensitive element may include one or more additional layers on or adjacent the photopolymerizable layer. In most embodiments, the one or more additional layers are on a side of the photopolymerizable layer opposite the support. Additional layers in the photosensitive element also encompass printing plate blanks that include more than one photopolymerizable layer, and thus can be a bi- or multi- layer construction. Examples of additional layers include, but are not limited to, a release layer, a protective layer, a capping layer, an elastomeric layer, a barrier layer, a wax layer, an actinic-radiation opaque layer, infrared-sensitive layer, and combinations thereof. The one or more additional layers can be removable, in whole or in part, during treatment. One or more of the additional layers may cover or only partially cover the photosensitive composition layer. Depending on desired use, the additional layers may be opaque or transparent to actinic radiation. As is well understood by those skilled in the art, the one or more additional layers may have one or more functions for the flexographic printing plate. It is well within the ordinary skill of those in the art to select and prepare additional layers on or adjacent the photopolymerizable layer according to desired end-use.

The flexographic printing plate optionally comprises a temporary cover sheet on top of the outermost layer of the flexographic printing plate. Useful cover sheets consist of flexible polymeric films, e.g., polystyrene, polyethylene, polypropylene, polycarbonate, or polyesters. Preferably, polyesters are used, especially polyethylene terephthalate. Mostly, the cover sheet is unsubbed, but optionally may be subcoated with a thin silicone layer.

The present invention will be explained in greater detail by means of the following examples.

<u>EXAMPLES</u>

<u>Test for Coefficient of Static Friction</u>

The coefficient of friction of the carrier was performed in a room having between 40 - 60% relative humidity and at a temperature between 15 to 18°C. A wooden board, 20 mm thick and 92 cm long, was used as an incline plane for the test. The interface material, i.e., carrier, being tested was attached with adhesive tape to cover one side of the wooden board and a side of a 200g calibration weight that faces the board. The calibration weight was placed on the board so that the surfaces of the board and calibration weight that have the interface material are in contact. One end of the wooden board was lifted via a Vestergaard 2500 manually-operated hydraulic lift device (Model 115-449T) to a height at which the calibration weight on the board began to move (down the incline plane of the board). The vertical height of the end of the board that was lifted was measured, in centimeters. The test was conducted six times and the height measurement was averaged and used for the calculation of the coefficient of friction. The tangent of the angle of inclination, corresponding to the static coefficient of friction, was determined via known basic trigonometry, based on the measured height (h) and the known length of the board (I), where the coefficient of static friction was calculated by first determining the angle alpha, $\alpha$, from the equation;

$$\text{Sine } \alpha = \text{height (h)} \div \text{board length (I)}$$

Then determining the coefficient of static friction, $\mu_s$, based on the following equation: $\mu_s$ = tangent of $\alpha$ = sine $\alpha$ ÷ cosine $\alpha$.

| | MELINEX® 506D | MYLAR® 100A | Silicone coated MYLAR® 601* |
|---|---|---|---|
| Ave. height of lifted end of board (cm) | 33.7 | 30.6 | 17.1 |
| Sine <u>$\alpha$</u> =h/l | 0.357608696 | 0.332428 | 0.185688 |
| <u>A</u> | 20.95 | 19.42 | 10.70 |
| Cos <u>$\alpha$</u> | 0.933872 | 0.943129 | 0.982609 |

(continued)

|  | MELINEX® 506D | MYLAR® 100A | Silicone coated MYLAR® 601* |
|---|---|---|---|
| Coefficient of friction, $\mu_s$ | 0.38 | 0.35 | 0.19 |
| *MYLAR® 601 polyester is MYLAR® type A polyester having one side silicone coated. | | | |

Example 1

A) A packaging assembly according to the invention was prepared with a packaging container, a carrier, intermediate foam layers, and printing plate blanks. The packaging container, as provided by a conventional supplier, was made of cardboard having a honeycomb base with coated cardboard arranged thereupon and had an inside measurement of approximately 900 x 1200 mm. The carrier was MYLAR® 601 polyester (from DuPont Teijin Films) which is unilaterally silicone-coated (i.e., one planar side of the polyester was coated with silicone), having a layer thickness of 0.125 mm, and a measurement of approximately 900 x 1200 mm. The Mylar® 601 had a coefficient of static friction of 0.19 on the coated side according to the above test method. The foam layers used were made of closed-cell polyolefin foam having a thickness of 2 mm. The blank printing plate was CYREL® DFH100 photopolymer printing plate (from DuPont). (Type DFH100 plate has a photopolymerizable layer thickness of about 2.45 mm, and a Shore A hardness of the unexposed photopolymerizable layer of 21.)

For each packaging assembly, the carrier was placed on the base of the container with the silicone coated-side facing away from the base and toward a first foam intermediate layer. A first printing plate was placed on top of the first foam layer. A foam layer was placed on top of the first printing plate, and seven more plates with a foam layer between each plate were stacked on top. Another foam layer was arranged on the uppermost plate. (Stack included bottom foam layer, eight plates alternating with foam layers, and topped with foam layer.) The packaging container was filled-up with layers rectangular of corrugated cardboard, and a lid to the container was placed on top.

Nine more packaging assemblies were made as described, and then stacked one upon the other for a single stack of 10 packaging assemblies. Five more stacks of 10 packaging assemblies were erected, for a total of 6 stacks of packaging assemblies.

B) As a comparison, another packaging assembly was prepared as described in Example 1A except that the assembly did not include the carrier. Multiple packaging assemblies of the comparative packaging assembly were prepared to provide an equivalent set of 6 stacks, each having 10 packaging assemblies.

All stacks of the packaging assemblies of Example 1A and Example 1B were stored for three weeks in a room in which the room temperature fluctuated between 15 and 25°C, and the relative humidity was between 30 and 75%.

Example 2

A) Twenty identical packaging assemblies according the invention were prepared as described in Example 1A, except for the following. A high density fibreboard (HDF board) was included on the honeycomb base of the packaging container that had an inside measurement of approximately 1270 by 1651 mm. The packaging containers were packed with CYREL® DPC185 blank printing plates (from DuPont). The DPC185 plate has a photopolymerizable layer thickness of about 4.64 mm and a Shore A hardness of the unexposed photopolymer layer of approximately 15). The packaging assembly included the carrier sheet of Mylar®601 unilaterally silicone-coated polyester.

Ten of the packaging assemblies according to the invention were prepared and stacked on top of one another.

B) As a comparison, ten packaging assemblies were prepared and stacked as in Example 2A, except that each of the comparative packaging assemblies did not include the carrier sheet.

The stacks were stored for three weeks under the room conditions given in Example 1.

Example 3

A) Seventy identical packaging assemblies were prepared according to the invention as described in Example 1A, except for the following. The carrier made of unilaterally silicone-coated polyester (Mylar 601® (from DuPont Teijin Films), having a coefficient of static friction of 0.19 on the coated side) was first arranged on the base with the coated-side facing the base of the packaging container (and the uncoated side facing the first printing plate). The printing plate was CYREL® DFH67 photopolymer printing plate (from DuPont). The DFH67 plate has a photopolymerizable layer thickness of approximately 1.6 mm and a Shore A hardness of the unexposed photopolymer layer of approximately 37. A foam intermediate layer was place on the uncoated side of the carrier, and a first plate was placed on top of the foam intermediate layer. A foam layer was placed on top of the first plate, and seven additional plates alternating with layers of the foam were stacked on top of the first plate. Another foam layer was arranged on the uppermost plate of the stack. The packaging container was filled up with layers of rectangular corrugated cardboard. Ten packaging assemblies were placed one on top of another to form a stack, for a total of seven stacks.

B) As a comparison, ten packaging assemblies were prepared as described in Example 3A) with the difference that a carrier made of uncoated polyester MYLAR® 100A polyester (from DuPont Teijin Films), having a thickness of 0.125 mm was used. (Note that MYLAR® 100A polyester may also be identified as MYLAR® 400A polyester.) The uncoated Mylar® 100A was tested according to the above test method to have a coefficient of static friction of about 0.35 (and the manufacturer reported a coefficient of friction of 0.36, as per ASTM 1894 test method). The ten equivalent packaging assemblies were placed one on top of one another for a stack.

C) Furthermore, as another comparative, ten packaging assemblies were prepared as disclosed in Example 3A) with the difference that the carrier made of uncoated polyester Melinex® 506D polyester (from DuPont Teijin Films) having a thickness of 0.125 mm was used. The carrier of Example 3C had a coefficient of static friction of approximately 0.35 as per the above test method. The ten equivalent packaging containers were stacked on top of one another.

All stacks from Examples 3A, 3B, and 3C were stored for three weeks under the conditions described in Example 1.

Test Results

After storage for the designated time the packaging containers of the packaging assemblies described in Examples 1A, 1B, 2A, 2B, 3A, 3B, and 3C, were opened, and the printing plates contained therein were examined.

Example 1A

After storage, none of the blank printing plates in a packaging container showed any change to their planar shape. Even the bottom-most blank printing plate of each packaging assembly exhibited no change in quality, i.e., the photopolymerizable layer had a planar surface of uniform thickness.

Example 1B (Comparison)

After storage, the bottom-most blank printing plate of each container exhibited a washboard-like structure. This structure was particularly pronounced in the bottom 1 to 7 packaging assemblies of each stack. The variation in the thickness of the photopolymerizable layer in this region was more than 50 μm. This variation in thickness exceeded the acceptable limit for quality-oriented flexographic printing, which is about plus/minus 25 μm.

Example 2A

After storage, none of the blank printing plates in any of the packaging assemblies showed any change in planar shape. Even the bottom-most blank printing plate of a packaging assembly exhibited no change in quality, i.e., the photopolymerizable layer of the printing plates had a uniform thickness with no changes in the planar surface.

Example 2B (Comparison)

After storage, the bottom-most blank printing plate of a packaging assembly had a washboard-like surface.

Example 3A

After storage, none of the blank printing plates in any of the packaging assemblies showed any change in planarity. Even the bottom-most blank printing plate of each packaging container exhibited no change in quality, i.e., the photopolymerizable layer had a uniform planar surface with no changes in thickness.

Example 3B (Comparison)

After storage, the bottom-most blank printing plate of a packaging assembly had a washboard-like surface. For the stack of 10 packaging assemblies, the washboard effect in the bottom-most plate of a packaging assembly increased in intensity (i.e., got worse) the closer the packaging assembly was to the bottom of the stack of the packaging assemblies. The intensity of the washboard effect was based on the degree of non-uniformity of the photopolymerizable thickness and/or the number of "ripples" forming the washboard.

Example 3C (Comparison)

After storage, the bottom-most blank printing plate of each packaging assembly had a washboard-like surface. For the stack of 10 packaging assemblies, the washboard effect in the bottom-most plate of a packaging assembly increased in intensity (i.e., got worse) the closer the packaging assembly was to the bottom of the stack of the packaging assemblies. The intensity of the washboard effect was based on the degree of non-uniformity of the photopolymerizable thickness and/or the number of "ripples" forming the washboard.

**Claims**

1. A packaging assembly for flexographic printing plates comprising:

   a packaging container having a base; and
   at least one flexographic printing plate positioned in the container adjacent the base, the at least one flexographic printing plate comprising an elastomeric photopolymerizable layer of a composition comprising a binder, at least one monomer, and at least one photoinitiator or photoinitiator system, that is adjacent a support, the elastomeric photopolymerizable layer having a thickness between 0.6 and 7 mm, wherein an interface having a coefficient of static friction of less than 0.30 is disposed between the plate and the base.

2. The packaging assembly of Claim 1 wherein the interface comprises a carrier.

3. The packaging assembly of Claim 2 wherein the carrier comprises a foil-like member selected from the group consisting of polyesters, polyolefins, polyurethanes, polyamides, polystyrenes, polycarbonates, and combinations thereof.

4. The packaging assembly of Claim 2 wherein the carrier comprises a self-support film of a fluoropolymer.

5. The packaging assembly of Claim 2 wherein the carrier comprises a planar surface having a coating of a material selected from the group consisting of a silicone, a silicone-containing material, a fluorinated polymer, and combinations thereof.

6. The packaging assembly of Claim 1 wherein the interface comprises a coating on the base.

7. The packaging assembly of Claim 6 wherein the coating comprises a material selected from the group consisting of a silicone, a silicone-containing material, a fluorinated polymer, and combinations thereof.

8. The packaging assembly of Claim 1 wherein the interface comprises a layer secured to the base and forming an interior surface of the base.

9. The packaging assembly of Claim 1 further comprising an intermediate layer disposed between the base and the interface.

10. The packaging assembly of Claim 1 further comprising an intermediate layer disposed between the plate and the interface.

11. A method for packing a flexographic printing plate comprising:

    providing a packaging container having a base;
    positioning at least one flexographic printing plate in the container adjacent the base, the at least one flexographic printing plate comprising an elastomeric photopolymerizable layer of a composition comprising a binder, at least one monomer, and at least one photoinitiator or photoinitiator system, that is adjacent a support, the elastomeric photopolymerizable layer having a thickness between 0.6 and 7 mm; and

disposing an interface having a coefficient of static friction of less than 0.30 between the plate and the base.

12. The method of Claim 11 wherein the interface is a carrier.

13. The method of Claim 12 wherein the carrier comprises a foil-like member selected from the group consisting of polyesters, polyolefins, polyurethanes, polyamides, polystyrenes, polycarbonates, and combinations thereof.

14. The method of Claim 11 wherein disposing the interface comprises securing a carrier to the base forming an interior surface of the base.

15. The method of Claim 11 further comprising disposing an intermediate layer between the base and the interface, or between the plate and the interface.


**Patentansprüche**

1. Verpackungsanordnung für flexographische Druckplatten, umfassend:

   einen Verpackungsbehälter, der einen Boden aufweist; und
   mindestens eine flexographische Druckplatte, die in dem Behälter am Boden anliegend positioniert ist, wobei die mindestens eine flexographische Druckplatte eine elastomere photopolymerisierbare Schicht einer Zusammensetzung umfasst, die ein Bindemittel, mindestens ein Monomer und mindestens einen Photoinitiator oder ein Photoinitiatorsystem umfasst, die an einem Träger anliegt, wobei die elastomere photopolymerisierbare Schicht eine Dicke zwischen 0,6 und 7 mm aufweist, wobei eine Grenzfläche, die einen Koeffizient statischer Reibung von weniger als 0,30 aufweist, zwischen der Platte und dem Boden angeordnet ist.

2. Verpackungsanordnung nach Anspruch 1, wobei die Grenzfläche einen Träger umfasst.

3. Verpackungsanordnung nach Anspruch 2, wobei der Träger ein folienartiges Element umfasst ausgewählt aus der Gruppe bestehend aus Polyestern, Polyolefinen, Polyurethanen, Polyamiden, Polystyrolen, Polycarbonaten und Kombinationen davon

4. Verpackungsanordnung nach Anspruch 2, wobei der Träger eine selbsttragende Folie aus einem Fluorpolymer umfasst.

5. Verpackungsanordnung nach Anspruch 2, wobei der Träger eine planare Oberfläche umfasst, die eine Beschichtung aus einem Material aufweist ausgewählt aus der Gruppe bestehend aus einem Silicon, einem Silicon enthaltenden Material, einem fluorierten Polymer und Kombinationen davon

6. Verpackungsanordnung nach Anspruch 1, wobei die Grenzfläche eine Beschichtung auf dem Boden umfasst.

7. Verpackungsanordnung nach Anspruch 6, wobei die Beschichtung ein Material umfasst, ausgewählt aus der Gruppe bestehend aus einem Silicon, einem Silicon enthaltenden Material, einem fluorierten Polymer und Kombinationen davon.

8. Verpackungsanordnung nach Anspruch 1, wobei die Grenzfläche eine Schicht umfasst, die an dem Boden befestigt ist und eine Innenfläche des Bodens bildet.

9. Verpackungsanordnung nach Anspruch 1, ferner eine Zwischenschicht umfassend, die zwischen dem Boden und der Grenzfläche angeordnet ist.

10. Verpackungsanordnung nach Anspruch 1, ferner eine Zwischenschicht umfassend, die zwischen der Platte und der Grenzfläche angeordnet ist.

11. Verfahren zum Verpacken einer flexographischen Druckplatte, umfassend:

das Bereitstellen eines Verpackungsbehälters, der einen Boden aufweist;
das Positionieren mindestens einer flexographischen Druckplatte in den Behälter am Boden anliegend, wobei die mindestens eine flexographische Druckplatte eine elastomere photopolymerisierbare Schicht einer Zusammensetzung umfasst, die ein Bindemittel, mindestens ein Monomer und mindestens einen Photoinitiator oder ein Photoinitiatorsystem umfasst, die an einem Träger anliegt, wobei die elastomere photopolymerisierbare Schicht eine Dicke zwischen 0,6 und 7 mm aufweist;
und das Anordnen einer Grenzfläche, die einen Koeffizient statischer Reibung von weniger als 0,30 aufweist, zwischen der Platte und dem Boden.

12. Verfahren nach Anspruch 11, wobei die Grenzfläche ein Träger ist.

13. Verfahren nach Anspruch 12, wobei der Träger ein folienartiges Element umfasst, das aus der Gruppe bestehend aus Polyestern, Polyolefinen, Polyurethanen, Polyamiden, Polystyrolen, Polycarbonaten und Kombinationen davon ausgewählt wird.

14. Verfahren nach Anspruch 11, wobei das Anordnen der Grenzfläche das Befestigen eines Trägers am Boden umfasst, wodurch eine Innenfläche des Bodens gebildet wird.

15. Verfahren nach Anspruch 11, ferner das Anordnen einer Zwischenschicht zwischen dem Boden und der Grenzfläche oder zwischen der Platte und der Grenzfläche umfassend.

## Revendications

1. Ensemble emballage pour plaques d'impression flexographique comprenant:

   un conteneur d'emballage ayant une base; et
   au moins une plaque d'impression flexographique positionnée dans le conteneur adjacent à la base, la au moins une plaque d'impression flexographique comprenant une couche photopolymérisable élastomère d'une composition comprenant un liant, au moins un monomère, et au moins un photoinitiateur ou un système photoinitiateur, qui est adjacent au support, la couche photopolymérisable élastomère présentant une épaisseur comprise entre 0,6 et 7 mm, où une interface ayant un coefficient de frottement statique inférieur à 0,30 est disposée entre la plaque et la base.

2. Ensemble emballage selon la revendication 1 dans lequel l'interface comprend un support.

3. Ensemble emballage selon la revendication 2 dans lequel le support comprend un élément de type feuille sélectionné dans le groupe constitué des polyesters, des polyoléfines, des polyuréthanes, des polyamides, des polystyrènes, des polycarbonates, et de combinaisons de ceux-ci.

4. Ensemble emballage selon la revendication 2 dans lequel le support comprend un film autoportant d'un polymère fluoré.

5. Ensemble emballage selon la revendication 2 dans lequel le support comprend une surface plane ayant un revêtement d'un matériau sélectionné dans le groupe constitué d'une silicone, d'un matériau contenant de la silicone, d'un polymère fluoré, et de combinaisons de ceux-ci.

6. Ensemble emballage selon la revendication 1 dans lequel l'interface comprend un revêtement sur la base.

7. Ensemble emballage selon la revendication 6 dans lequel le revêtement comprend un matériau sélectionné dans le groupe constitué d'une silicone, d'un matériau contenant de la silicone, d'un polymère fluoré, et de combinaisons de ceux-ci.

8. Ensemble emballage selon la revendication 1 dans lequel l'interface comprend une couche solidement fixée à la base et formant une surface intérieure de la base.

9. Ensemble emballage selon la revendication 1 comprenant en outre une couche intermédiaire disposée entre la base et l'interface.

**10.** Ensemble emballage selon la revendication 1 comprenant en outre une couche intermédiaire disposée entre la plaque et l'interface.

**11.** Procédé d'emballage d'une plaque d'impression flexographique comprenant:

la préparation d'un conteneur d'emballage ayant une base;
le positionnement d'au moins une plaque d'impression flexographique dans le conteneur adjacent à la base, la au moins une plaque d'impression flexographique comprenant une couche photopolymérisable élastomère d'une composition comprenant un liant, d'au moins un monomère, et d'au moins un photoinitiateur ou un système photoinitiateur, qui est adjacent à un support, la couche photopolymérisable élastomère ayant une épaisseur comprise entre 0,6 et 7 mm; et
la mise en place d'une interface ayant un coefficient de frottement statique inférieur à 0,30 entre la plaque et la base.

**12.** Procédé selon la revendication 11 dans lequel l'interface est un support.

**13.** Procédé selon la revendication 12 dans lequel le support comprend un élément de type feuille sélectionné dans le groupe constitué des polyesters, des polyoléfines, des polyuréthanes, des polyamides, des polystyrènes, des polycarbonates, et de combinaisons de ceux-ci.

**14.** Procédé selon la revendication 11 dans lequel la mise en place de l'interface comprend la fixation ferme d'un support à la base formant une surface intérieure de la base.

**15.** Procédé selon la revendication 11 comprenant en outre la mise en place d'une couche intermédiaire entre la base et l'interface, ou entre la plaque et l'interface.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4323637 A
- US 4427759 A
- EP 0528395 A
- JP 9292713 A
- US 5015556 A